# EUROPEAN PATENT APPLICATION

(11) **EP 2 099 064 A1**
(43) Date of publication of application: **09.09.2009**
(21) Application number: 08102378.0
(22) Date of filing: 07.03.2008
(51) Int. Cl.: H01L 21/336, H01L 21/20, H01L 29/786, H01L 21/77

(54) **Method for manufacturing a semiconductor device**

(71) Applicant: Technische Universiteit Delft, 2628 CN Delft (NL)
(72) Inventor: Ishihara, Ryoichi, 2289 BM Rijswijk (ZH) (NL); Baiano, Alessandro, 2613 EH Delft (NL)
(74) Representative: Van Breda, Jacobus

(57) **Abstract**

The invention relates to a method for manufacturing a semiconductor device on a substrate provided with a silicon-oxide layer, by forming at least one hole in said silicon-oxide layer and depositing on said silicon-oxide layer an amorphous silicon-film which fills said at least one hole and covers a surrounding area of said hole, wherein said silicon-film is subjected to irradiation so as to convert at least the amorphous silicon in said at least one hole into a substantially recrystallized silicon by melting at least part of the silicon inside of the at least one hole and subsequently generating crystal growth inside said at least one hole, wherein the silicon inside the at least one hole is completely melted prior to generating said crystal growth, and wherein said crystal growth occurs through the generation at random of nuclei in said completely melted silicon by undercooling of said melted silicon.

## Description

The invention relates to a method for manufacturing a semiconductor device on a substrate provided with a silicon-oxide layer, by forming at least one hole in said silicon-oxide layer and depositing on said silicon-oxide layer an amorphous silicon-film which fills said at least one hole and covers a surrounding area of said hole, wherein said silicon-film is subjected to irradiation so as to convert at least the amorphous silicon in said at least one hole into a substantially recrystallized silicon by melting at least part of the silicon inside of the at least one hole and subsequently generating crystal growth inside said at least one hole.

Such a method is known from US-B-6,940,143.

According to this known prior art an insulating film having a through hole between two layers of silicon-film is provided. The silicon-film is partially melted by irradiating a laser thereon, whereby a substantially monocrystalline film is continuously formed extending via the through hole from at least part of the layer of silicon-film below the insulating film that continues to the through hole to at least part of the layer of silicon-film above the insulating film.

In the field of manufacturing of thin film transistors having a silicon layer recrystallized by application of an excimer laser, and wherein the monocrystallized silicon layer acts as the channel between source and drain of the transistor, it is known that the electron field effect mobility is limited to 700 cm²/vs.

It is an object of the invention to improve the manufacturing method of the semiconductor device such that appreciable higher values of both the hole- and the electron field effect mobility can be attained. The invention is consequently also embodied in a transistor manufactured according to this method.

The method and transistor of the invention is to that end characterized by one or more of the appended claims.

In a first aspect of the invention the method for manufacturing a semiconductor device on a substrate with a silicon oxide layer in which at least one hole is formed and on top of which an amorphous silicon-film is deposited, which fills said hole is characterized in that the silicon inside the at least one hole is completely melted prior to generating said crystal growth, and that said crystal growth occurs through the generation at random of nuclei in said completely melted silicon by undercooling of said melted silicon.

It is found that this manufacturing method induces tensile stresses into the silicon layer which dramatically increases the mobility of electrons and holes of the transistor. Furthermore, the strained silicon layer also has an extremely flat surface, and the resulting electron and hole mobilities may arrive at values of 1200 cm²/vs and 500 cm²/vs, respectively.

Preferably, the silicon inside the at least one hole is completely melted by applying irradiation from a pulsed laser having a pulse duration in the range 10 nsec - 1 µsec. so as to cause that said silicon in said hole receives an energy-density of less than 248 mJ/cm². This secures that a complete melt of the silicon inside the hole can be attained without yet causing that the silicon may partly ablate.

It is important to note that the crystal growth that occurs in the silicon inside the hole occurs through the generation at random of nuclei, which are induced by undercooling of the melted silicon. Undercooling means that the molten silicon is cooled down to a temperature of several hundreds of degrees below the melting point of crystalline silicon, for instance around 400 degrees below said melting point. Also, the solidification of the silicon will speed up due to the undercooling, which will give rise to significant strain in the crystallized silicon. It is at this point remarked that US-B-6,940,143 does not teach the generation at random of nuclei in the melted silicon, yet discusses that the solidification of silicon following the laser irradiation begins first with the partly melted amorphous silicon film lying underneath the silicon oxide layer. In this process the not melted parts of the underlying silicon-film act as a seed for the crystallization of the melted parts, while the formation of nuclei in the melted silicon does not occur.

It is found advantageous that the irradiation of the silicon film is performed by application of a pulsed laser at an energy-level that depends on said laser's pulse duration. In particular it is found that the energy level of the pulsed laser should be selected inversely proportionate to the square of the pulse duration. This secures that at all times sufficient energy arrives at the silicon in the hole so as to cause that a complete melt of this silicon is obtained.

It is further remarked that due to the circumstance that in fact the method of the invention for manufacturing a semiconductor device is a low temperature process, a wide variety of substrates can be used, for instance bulk silicon, silicon on insulator, metal, glass or even plastic substrates. It is preferred that the pulse-duration of the pulsed laser is less than 200 nsec. when the substrate is selected to be a plastic substrate.

The invention shall hereinafter be further elucidated with reference to a manufacturing example and with reference to the drawing.

In the drawing:
- Fig. 1 shows a thin film transistor manufactured in accordance with the method of the invention;
- Fig. 2 and Fig. 3 show graphs representing the relation between pulse duration and energy absorbed by the silicon in the hole, whereby a silicon substrate (Fig. 2) is used and a plastic substrate (Fig. 3) is used respectively.

The manufacturing method of the invention may proceed as follows.

First, small cavities with a diameter of 100 nm and a depth of 750 nm are made in SiO₂ by conventional photolithographic patterning and etching of 1 µm diameter holes following by in-complete filling of the hole by an additional SiO₂ deposition. A wide variety of substrates can be used, e.g., bulk-Si, SOI (Silicon-on-insulator), glass or plastic substrates. The cavities are filled with a 250 nm thick a-Si film deposited by low pressure chemical vapour deposition LPCVD (This can however also be an other deposition method like PECVD or sputtering).

Next, a pulsed laser such as an excimer-laser with a very high energy density (over 1.2 J/cm2 in case of an XeCl Excimer-Laser with 23 ns pulse width) irradiates the surface of the amorphous Si. It is important to use a very high energy density such that the a-Si inside the cavity (grain filter) completely melts.

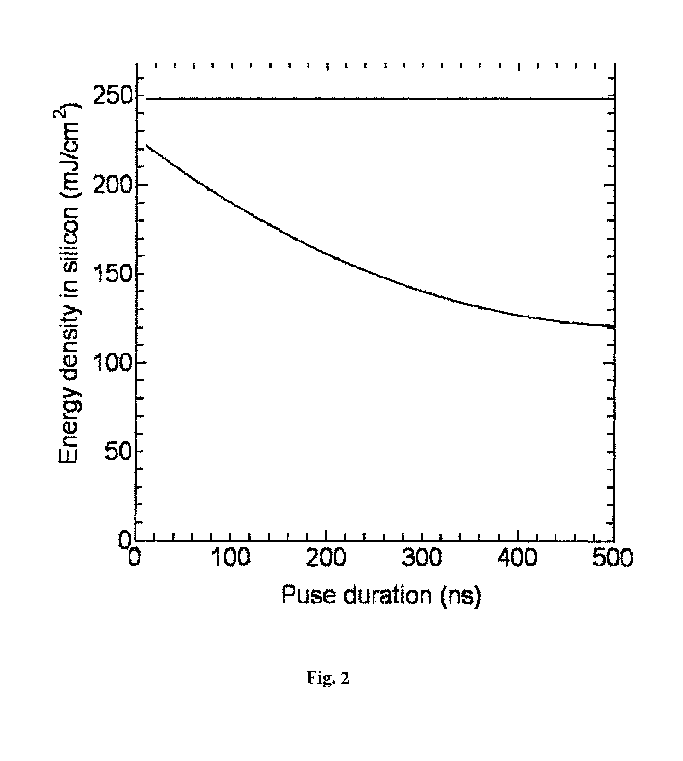

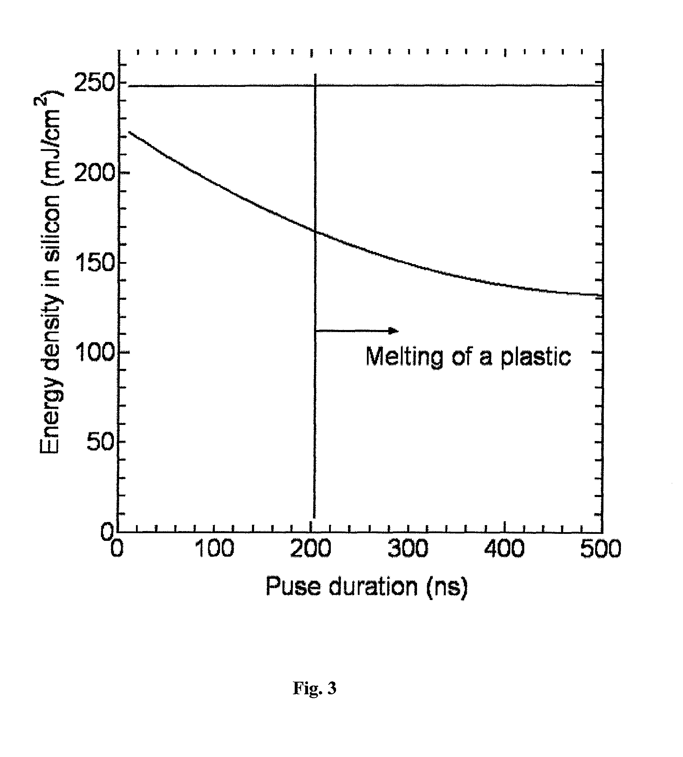

Fig. 2 and Fig. 3 show the restrictions for the absorbed energy at the silicon in the hole, depending on whether the substrate is SiO₂ (Fig. 2) or is a plastic substrate (Fig. 3).

In both cases the energy density of the silicon in the hole is restricted to an amount of 248 mJ/cm².

Fig. 2 and Fig. 3 also show that the irradiation of the silicon film by the pulsed laser occurs at an energy level that depends on the laser's pulse duration such that the energy level of the pulsed laser is inversely proportionate to the square of the pulse duration.

After the irradiation of the pulsed laser and cooling down, nuclei will be generated at the bottom of the grain filter where the temperature is the lowest. Grain growth takes place from the nuclei. Random grain boundaries are removed during the vertical growth through the narrow cavities. Finally Si grains with a diameter of 6 µm can be obtained precisely on top of the grain filter. Because of the rapid crystal growth from the completely melted Si, the location-controlled Si grain has a certain tensile stress. Surface roughness is also reduced.

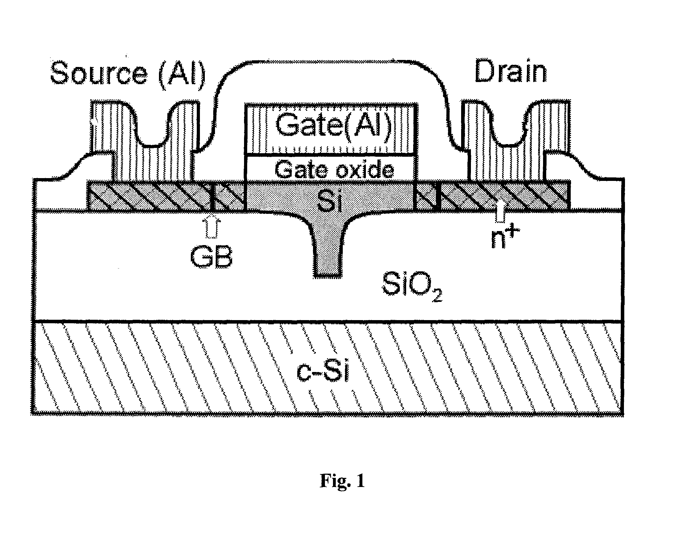

Fig. 1 shows a schematic structure of an N-channel single gate thin film transistor that is manufactured in accordance with the method of the invention. Such a transistor is fabricated by using the location-controlled grain as a channel with a length and width that ranges from 1 micrometer to 5 micrometer. After patterning the silicon in an island for the channel, the source and the drain a gate oxide is deposited by a low temperature chemical vapour deposition. After formation of a gate electrode on top thereof in the form of an aluminium gate, the source and drains are implanted by phosphorous to attain an N-channel. If boron ions are used for implanting the source and drains a p-channel transistor can be attained.

It is measured that the maximum field effect mobilities for electrons and holes of the transistor manufactured in accordance with the invention are as high as 1200 cm²/vs and 500 cm²/vs, respectively.

The transistor of the invention can suitably be applied in any type of application, particularly however in ultra wide-band communication circuits integrated with a flat-panel display.

## Claims

1. Method for manufacturing a semiconductor device on a substrate provided with a silicon-oxide layer, by forming at least one hole in said silicon-oxide layer and depositing on said silicon-oxide layer an amorphous silicon-film which fills said at least one hole and covers a surrounding area of said hole, wherein said silicon-film is subjected to irradiation so as to convert at least the amorphous silicon in said at least one hole into a substantially recrystallized silicon by melting at least part of the silicon inside of the at least one hole and subsequently generating crystal growth inside said at least one hole, **characterized in that** the silicon inside the at least one hole is completely melted prior to generating said crystal growth, and that said crystal growth occurs through the generation at random of nuclei in said completely melted silicon by undercooling of said melted silicon.

2. Method according to claim 1, **characterized in that** the silicon inside the at least one hole is completely melted by applying irradiation from a pulsed laser having a pulse duration in the range 10 nsec - 1 µsec. so as to cause that said silicon in said hole receives an energy-density of less than 248 mJ/cm².

3. Method according to claim 1 or 2, **characterized in that** the irradiation of the silicon film is performed by application of a pulsed laser at an energy-level that depends on said laser's pulse duration.

4. Method according to claim 3, **characterized in that** the energy-level of the pulsed laser is inversely proportionate to the square of the pulse duration.

5. Method according to any one of claims 1-4, **characterized in that** the pulse-duration of the pulsed laser is less than 200 nsec. when the substrate is selected to be a plastic substrate.

6. Transistor manufactured according to the method of anyone of claims 1-5.

7. Ultra wide-band communication circuit integrated with a flat panel display incorporating at least one transistor according to claim 6.
